(19) Europäisches Patentamt / European Patent Office / Office européen des brevets

(11) **EP 1 562 049 B1**

(12) **EUROPÄISCHE PATENTSCHRIFT**

(45) Veröffentlichungstag und Bekanntmachung des Hinweises auf die Patenterteilung:
**10.03.2010 Patentblatt 2010/10**

(51) Int Cl.:
***G01R 31/36*** *(2006.01)*

(21) Anmeldenummer: **05000566.9**

(22) Anmeldetag: **13.01.2005**

(54) **Verfahren zur Bestimmung von Kenngrössen für elektrische Zustände einer Speicherbatterie und Überwachungseinrichtung hierzu**

Method for the determination of characteristics for electrical states of a storage battery and corresponding monitoring device

Procédé pour la détermination de caractéristiques pour les états électriques d'une batterie d'accumulateurs et dispositif de surveillance correspondant

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **04.02.2004 DE 102004005478**

(43) Veröffentlichungstag der Anmeldung:
**10.08.2005 Patentblatt 2005/32**

(73) Patentinhaber: **VB Autobatterie GmbH & Co. KGaA 30419 Hannover (DE)**

(72) Erfinder: **Koch, Ingo 31789 Hameln (DE)**

(74) Vertreter: **Gerstein, Hans Joachim et al Gramm, Lins & Partner GbR Theodor-Hauss-Strasse 1 38122 Braunschweig (DE)**

(56) Entgegenhaltungen:
**DE-A1- 10 103 848    DE-B3- 10 216 637**

- DESMETTRE D ET AL: "EXPERIMENTAL STUDY OF STRATIFICATION OF ELECTROLYTE IN LEAD/ACID BATTERIES USED FOR SOLAR ENERGY" 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICSSPECIALISTS CONFERENCE. / 10TH ASIA/PACIFIC PV SCIENCE AND ENGINEERINGCONFERENCE. VIENNA, AUSTRIA, JULY 6 - 10, 1998, Bd. VOL. 2, 6. Juli 1998 (1998-07-06), Seiten 2135-2138, XP001138150 ISBN: 92-828-5419-1
- MATTERA F ET AL: "Characterisation of photovoltaic batteries using radio element detection: the influence and consequences of the electrolyte stratification" JOURNAL OF POWER SOURCES, ELSEVIER SEQUOIA S.A. LAUSANNE, CH, Bd. 113, Nr. 2, 27. Januar 2003 (2003-01-27), Seiten 400-407, XP004402936 ISSN: 0378-7753

**Beschreibung**

Die Erfindung betrifft ein Verfahren zur Bestimmung der noch entnehmbaren Restkapazität einer Speicherbatterie.

Die Erfindung betrifft weiterhin eine Überwachungseinrichtung für eine elektrochemische Speicherbatterie mit einer Messeinheit zur Messung der Batterieklemmenspannung, des Batterieklemmenstroms und der Batterietemperatur, und mit einer Auswerteeinheit.

Es besteht ein Bedarf, den Zustand einer elektrochemischen Speicherbatterie, wie beispielsweise den Ladezustand oder die Hochstrombelastbarkeit, aktuell zu bestimmen oder vorherzusagen. Beispielsweise sind für die Fähigkeit einer Starterbatterie, ein Kraftfahrzeug mit einem Verbrennungsmotor zu starten, der Ladezustand und der Alterungszustand bzw. der sich abzeichnende Kapazitätsverfall der Batterie maßgeblich, da die durch die Starterbatterie entnehmbare Stromstärke bzw. deren Leistungsabgabe begrenzt wird. Von besonderer Bedeutung ist die Ermittlung des Ladezustandes bzw. der Startfähigkeit einer Starterbatterie in den Fällen, in denen beispielsweise intermittierender Motorbetrieb vorliegt, da dann in den Motorstillstandszeiten das Bordnetz des Fahrzeuges mit seinen Verbrauchern weiter betrieben wird, allerdings der Generator keinen Strom erzeugt. Die Überwachung des Ladezustandes und der Startfähigkeit der Speicherbatterie muss in solchen Fällen gewährleisten, dass der Energieinhalt der Speicherbatterie stets ausreichend bleibt, um den Motor noch zu starten.

Zur Messung des Ladezustandes und der Bestimmung des Lastverhaltens von Speicherbatterien sind die verschiedensten Verfahren bekannt. So werden beispielsweise integrierende Messgeräte benutzt (Ah-Zähler), wobei der Ladestrom ggf. unter Bewertung mit einem festen Ladefaktor berücksichtigt wird. Da die nutzbare Kapazität einer Speicherbatterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE 22 42 510 C1 ist beispielsweise bekannt, bei einem Verfahren zur Messung des Ladezustandes den Ladestrom mit einem von der Temperatur und dem vom Ladezustand der Batterie selbst abhängigen Faktor zu bewerten.

In der DE 40 07 883 A1 ist ein Verfahren beschrieben, bei dem die Startfähigkeit einer Speicherbatterie durch Messung der Batterieklemmenspannung und der Batterietemperatur und Vergleich mit einer für den zu prüfenden Batterietyp geltenden Ladezustandskurvenschar ermittelt wird.

Der DE 195 43 874 A1 ist ein Berechnungsverfahren für die Entladungscharakteristik und Restkapazitätsmessung einer Speicherbatterie zu entnehmen, bei dem ebenfalls Strom, Spannung und Temperatur gemessen wird, wobei die Entladungscharakteristik durch eine mathematische Funktion mit gekrümmter Oberfläche angenähert wird.

In der DE 39 01 680 C1 ist ein Verfahren zur Überwachung der Kaltstartfähigkeit einer Starterbatterie beschrieben, bei dem die Starterbatterie zeitweise mit einem Widerstand belastet wird. Die am Widerstand abfallende Spannung wird gemessen und daraus im Vergleich mit Erfahrungswerten festgestellt, ob die Kaltstartfähigkeit der Starterbatterie noch ausreicht. Zur Belastung der Starterbatterie dient dabei der Anlassvorgang.

Weiterhin ist in der DE 43 39 568 A1 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird. Dabei wird zusätzlich auch die Batterietemperatur berücksichtigt. Die während verschiedener Zeiträume gemessenen Ladeströme werden miteinander verglichen und daraus eine Restkapazität ermittelt.

In der DE 198 47 648 A1 ist ein Verfahren zum Erlernen eines Zusammenhangs zwischen der Ruhespannung und dem Ladezustand einer Speicherbatterie zum Zweck der Abschätzung der Speicherfähigkeit beschrieben. Aus der Beziehung der Ruhespannungsdifferenz zur während der Belastungsphase umgesetzten Strommenge wird ein Maß für die Elektrolytkapazität des Elektrolyts der Speicherbatterie ermittelt. Dabei wird ausgenutzt, dass die Ruhespannung bei dem in der für die Praxis relevanten höheren Ladezustandsbereichen annähernd linear mit dem Ladezustand ansteigt.

Das Problem bei der Ermittlung des Zustandes einer elektrochemischen Speicherbatterie mit den vorbekannten Verfahren ist, dass insbesondere beim Entlade- und Ladetrieb wieder aufladbarer Speicherbatterien, aber auch bei der lastfreien Lagerung Verschleiß auftritt, wobei nicht alle relevanten Verschleißfaktoren berücksichtigt werden.

Im Falle eines Bleiakkumulators besteht der Elektrolyt aus verdünnter Schwefelsäure, d. h. eine Lösung von $H_2SO_4$ in Wasser. Typischerweise handelt es sich im vollständig geladenen Zustand um eine ca. 4 bis 5 molare Lösung. Bei der Entladereaktion wird entsprechend der Reaktionsgleichung

$$\text{Positive Elektrode: } PbAO_2 + H_2SO_4 + 2H^+ + 2e^- \rightarrow PbSO_4 + 2H_2O_4$$

$$\text{Negative Elektrode: } Pb + H_2SO_4 \rightarrow Pb + 2H^+ + 2e^-$$

im Elektrolyten $H_2SO_4$ an beiden Elektroden verbraucht und zudem $H_2O$ einer positiven Elektrode gebildet. Dadurch sinkt bei der Entladung die Konzentration und die spezifische Dichte des Elektrolyten, während sie bei der umgekehrt ablaufenden Ladereaktion wieder ansteigt.

Hat bei der Ladereaktion die gebildete Schwefelsäure die Möglichkeit einer Konvektion im Schwerefeld der Erde, so hat sie die Neigung in Schlieren zum Boden des Zellgefäßes der Zellen des Bleiakkumulators zu sinken. Dadurch liegt dann im unteren Bereich des jeweiligen Zellgefäßes ein Elektrolyt mit höherer Konzentration vor, als im oberen Bereich des Zellgefäßes. Dieser Zustand wird im Falle des Bleiakkumulators als Säureschichtung bezeichnet.

Da sowohl die Lade- / Entladereaktion als auch die parasitären Reaktionen, wie z. B. Gasentwicklung, Korrosion etc. im Allgemeinen von der Elektrolytkonzentration beeinflusst werden, führt eine Säureschichtung zu einer Verungleichmäßigung des Zustandes der Zelle.

D. U. Sauer: Modelling of Local Conditions in flooded Lead / Acid Batteries in Photovoltaic Systems, in: Journal of Power Sources 64 (1997), 181 -187 beschreibt ein Verfahren zur Modellierung einer Blei-Säure-Batterie mit Hilfe eines elektrischen Ersatzschaltbildes für die in drei Bereiche aufgeteilten Elektroden, um ein Strom-Spannungs-Verhältnis zu simulieren, das den Einfluss der Säureschichtung berücksichtigt. Weiterhin ist der Elektrolytraum in eine Vielzahl horizontal und vertikal angeordneter Elektrolytbilanzräume aufgeteilt.

Aufgabe der Erfindung ist es daher, ein verbessertes Verfahren zur Bestimmung von Kenngrößen für elektrische Zustände einer Speicherbatterie zu schaffen.

Die Aufgabe wird erfindungsgemäß gelöst durch die Schritte gemäß Anspruch 1.

Durch die Aufteilung der Speicherbatterie in Elektrolytbilanzräume und Elektrodenplatten-Bilanzräume ist es möglich, die komplexen physikalischen und chemischen Vorgänge in einer Speicherbatterie einschließlich der Säureschichtung mit einem mathematischen Modell zur Beschreibung eines elektrischen Ersatzschaltbildes der Speicherbatterie zu erfassen, um Kenngrößen für elektrische Zuständer Speicherbatterie zu bestimmen.

Dabei kann die Säuredichte eine Maßzahl für die Elektrolytkonzentration sein.

Vorteilhaft ist es, wenn Ruhespannungen in den festgelegten Elektrodenplatten-Bilanzräumen in Abhängigkeit von der Elektrolytkonzentration bzw. Säuredichte in einem zugeordneten Elektrolytbilanzraum bestimmt werden. Dabei gilt, dass jeweils ein Elektrodenplatten-Bilanzraum mit einem zugeordneten Elektrolytbilanzraum in Verbindung steht, nicht hingegen mit den anderen Elektrolytbilanzräumen. Bei der Berechnung der Ruhespannung in einem Elektrodenplaften-Bilanzraum wird berücksichtigt, dass dieser im Wesentlichen durch die Elektrolytkonzentration in dem zugeordneten Elektrolytbilanzraum, die umgesetzte Ladungsmenge sowie ggf. durch die Batterietemperatur beeinflusst wird.

Besonders vorteilhaft ist es, wenn Ströme für die Elektrolytbilanzräume aus den an den Anschlussklemmen der Speicherbatterie fließenden Gesamtstrom und einem von der Elektrolytkonzentration in dem jeweiligen Elektrolytbilanzraum abhängigen Teilungsverhältnis berechnet wird. Gleichermaßen können Ströme für die Elektrodenplatten-Bilanzräume aus den an den Anschlussklemmen der Speicherbatterie fließenden Gesamtstrom und einem von der Ruhespannung in dem jeweiligen Elektrodenplatten-Bilanzraum und den Widerstandsanteilen abhängigen Teilungsverhältnis berechnet werden.

Die Verteilung des Stroms auf die Elektrolyt- und Elektrodenplattenbilanzräume wird bevorzugt in Laderichtung unabhängig von der Verteilung des Stroms in Entladerichtung bewertet, wobei im Falle einer Entladung die Ströme für die Elektrolytbilanzräume den Strömen entsprechen, die für die Elektrodenplatten-Bilanzräume berechnet wurden.

Für Ladevorgänge hingegen unterscheiden sich die Teilungsverhältnisse zur Berechnung der Ströme für den Elektrolytbilanzraum von den Teilungsverhältnissen zur Berechnung der Ströme für die Elektrodenplatten-Bilanzräume.

Weiterhin ist es vorteilhaft, wenn die in einem Zeitraum in einem Elektrodenplatten-Bilanzraum entnommene Ladungsmenge berechnet wird, indem von der bis unmittelbar vor diesem Zeitraum umgesetzten Ladungsmenge in diesem Elektrodenplatten-Bilanzraum die in dem betrachteten Zeitraum durch den Elektrodenplatten-Bilanzraum geflossene Ladung abgezogen wird.

Die den Elektrodenplatten in den einzelnen Elektrodenplatten-Bilanzräumen noch entnehmbare Ladungsmenge kann somit aus dem Speicherkapazitätsanteil des jeweiligen Elektrodenplatten-Bilanzraumes vermindert um die bis zum betrachteten Zeitraum der Elektrodenplatten in dem Elektrodenplatten-Bilanzraum entnommenen Ladungsmenge und vermindert um die in dem Zeitraum den Elektrodenplatten in dem Elektrodenplatten-Bilanzraum entnommene Ladung berechnet werden.

Weiterhin kann die den Elektrolytvolumenanteilen in den einzelnen Elektrolytbilanzräumen noch entnehmbaren Ladungsmengen in Abhängigkeit von der aktuellen Elektrolytkonzentration und dem Elektrolytvolumen in dem jeweiligen Elektrolytbilanzraum und der Batterietemperatur berechnet werden.

Als Kenngröße wird die Restkapazität verwendet, die der Speicherbatterie noch entnommen werden kann, in Abhängigkeit von den für die Elektrodenplatten-Bilanzräume bestimmten Ladungsmengen, die den Elektrodenplatten der jeweiligen Elektrodenplatten-Bilanzräume noch entnehmbar sind, und den für die Elektrolytbilanzräume bestimmten Ladungsmengen, die den Elektrolytvolumenanteilen in den jeweiligen Elektrolytbilanzräumen noch entnehmbar sind.

Auch die Ruhespannung der Speicherbatterie kann als Kenngröße als Funktion von der umgesetzten Ladungsmenge ggf. bezogen auf die Speicherkapazität in den einzelnen Elektrodenplatten-Bilanzräumen, der Ruhespannungen in den Elektrodenplatten-Bilanzräumen, der Widerstandsanteile, des Polarisationswiderstandes und des Umladestroms durch Umladung an jeweils einer einzelnen Elektrodenplatte berechnet werden. Der zu berücksichtige Umladestrom entsteht dadurch, dass am Ort hoher Ruhespannung das aktive Material entladen wird und am Ort einer niedrigeren Ruhespannung eine Ladung erfolgt. Damit verbunden ist ein Spannungsabfall über den Polarisationswiderstand, der den Polarisationswiderstand an der Plattenoberfläche bei kleinen Strömen darstellt, und der einzelnen Gitterwiderstände der Elektrodenplattengitter. Dadurch ergibt sich eine Ruhespannung, deren Wert zwischen den Ruhespannungen der einzelnen Bilanzräume liegt (Mischpotential).

Es ist somit vorteilhaft, die Kenngröße in Abhängigkeit von dem Umladestrom an den Elektrodenplatten zwischen Orten höherer Ruhespannung und Orten niedriger Ruhespannung zu bestimmen, wobei der Umladestrom aus dem Polarisationswiderstand an den Elektrodenplattenoberflächen und der Summe der Gitterwiderstände zwischen den Orten nach der Formel:

$$I_U = \left(U_{\infty,x} - U_{\infty,y}\right) \cdot \left(R_{P,x} + R_{P,y} + \sum_{n=x}^{y} R_n\right)$$

berechnet wird.

Weiterhin ist es vorteilhaft, die für das Einsetzen einer Eiskristallbildung in den Bilanzräumen kritische Temperatur in Abhängigkeit von der Elektrolytkonzentration in den Elektrolytbilanzräumen, der Temperatur und den Elektrolytvolumenanteilen zu ermitteln. Dabei kann das Eiskristallvolumen in den Elektrolytbilanzräumen aus einem definierten Zusammenhang zwischen der Gleichgewichtskonzentration der Säure im Elektrolyten und der Temperatur sowie der Säurekonzentration im Elektrolyten nach der Formel:

$$v_{Eis,i'} = (1 - C_i/CGG_i) \cdot v_i$$

berechnet werden. Die Bewertung der Eisbildung für unterschiedliche Zonen ist somit durch die Betrachtung einzelner Bilanzräume und die Berechnung der Säuredichte in diesen Bilanzräumen möglich. Mit der Information über das Eisvolumen in jedem Elektrolytbilanzraum kann eine Aussage getroffen werden, ob durch das Eis die Speicherbatterie in Ihrer Leistungsfähigkeit beeinträchtigt wird. Dies kann z. B. so erfolgen, dass bei Auftreten von Eiskristallen nur im oberen Elektrolytbilanzraum die volle Leistungsfähigkeit der Batterie angenommen wird und hingegen bei Auftreten von Eiskristallen im untersten Elektrolytbilanzraum die Batterie als nicht mehr leistungsfähig angenommen wird.

Weiterhin ist es vorteilhaft, die Zustandswerte für die Elektrolytkonzentration in den Elektrolytbilanzräumen in Abhängigkeit von der Differenz zwischen der tatsächlichen Ruhespannung und der berechneten Ruhespannung anzupassen. Hierdurch wird z. B. eine durch Bewegung der Batterie verursachte Mischung der Säure berücksichtigt, die in dem Modell nicht berücksichtigt werden kann, da nur der Batterieklemmenstrom und die Batterieklemmenspannung gemessen werden.

Aufgrund möglicherweise unterschiedlichen Verhaltens von Außenbereichen der Speicherbatterie ist es weiterhin vorteilhaft, wenn Außenbereichen getrennter Elektrolytbilanzräume zugewiesen werden, die separat zu den übrigen Elektrolytbilanzräumen bewertet werden.

Aufgabe der Erfindung ist es weiterhin eine verbesserte Überwachungseinrichtung zu schaffen.

Die Aufgabe wird mit der gattungsgemäßen Überwachungseinrichtung dadurch gelöst, dass die Auswerteeinheit zur Durchführung des oben beschriebenen Verfahrens beispielsweise durch Programmierung einer Mikroprozessoreinheit ausgebildet ist.

Die Erfindung wird nachfolgend beispielhaft anhand der beigefügten Zeichnungen näher erläutert:

Figur 1 - Elektrisches Ersatzschaltbild einer in Säurebilanzräume und Elektrodenplatten-Bilanzräume eingeteilten Speicherbatterie für den Fall der Entladung;

Figur 2 - Elektrisches Ersatzschaltbild der Speicherbatterie aus Figur 1 mit den Säurebilanzräumen und Elektrodenplatten-Bilanzräumen zugeordneten Strömen für den Fall der Ladung;

Figur 3 - Diagramm einer Funktion $f_L$ in Abhängigkeit von der auf einen Speicherkapazitätsanteil bezogenen entnommenen Ladungsmenge in einem Elektrodenplatten-Bilanzraum zur Berechnung der Ladestromverteilung in den Elektrodenplatten-Bilanzräumen;

Figur 4 - Diagramm einer Funktion $f_E$ in Abhängigkeit von der auf einen Speicherkapazitätsanteil bezogenen entnommenen Ladungsmenge zur Berechnung der Entladestromverteilung;

Figur 5 - Diagramm des aus der Ladungsbilanz berechneten Ladezustands einer Speicherbatterie über die Zeit;

Figur 6 - Diagramm der aus dem Modell der Speicherbatterie mit dem elektrischen Ersatzschaltbild berechneten Ruhespannung und der tatsächlich gemessenen unbelasteten Spannung einer Speicherbatterie über die Zeit;

Figur 7 - Diagramm der Säuredichte in den Säurebilanzräumen einer Speicherbatterie über die Zeit;

Figur 8 - Diagramm des Verlustes an Speicherfähigkeit einer Speicherbatterie über der Zeit;

Figur 9 - Diagramm der Restkapazität in den Säure- und zugeordneten Elektrodenplatten-Bilanzräumen über die Zeit;

Figur 10 - Diagramm der entnehmbaren Speicherkapazität über die Zeit.

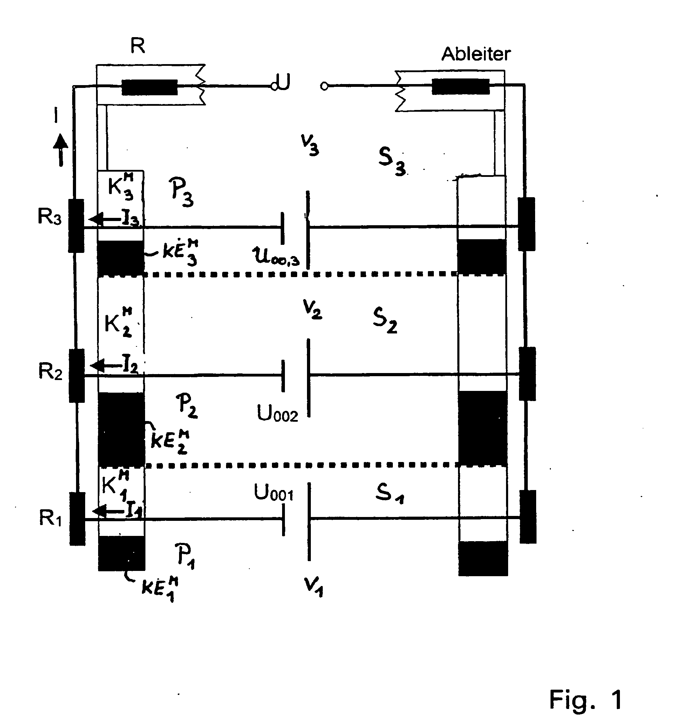

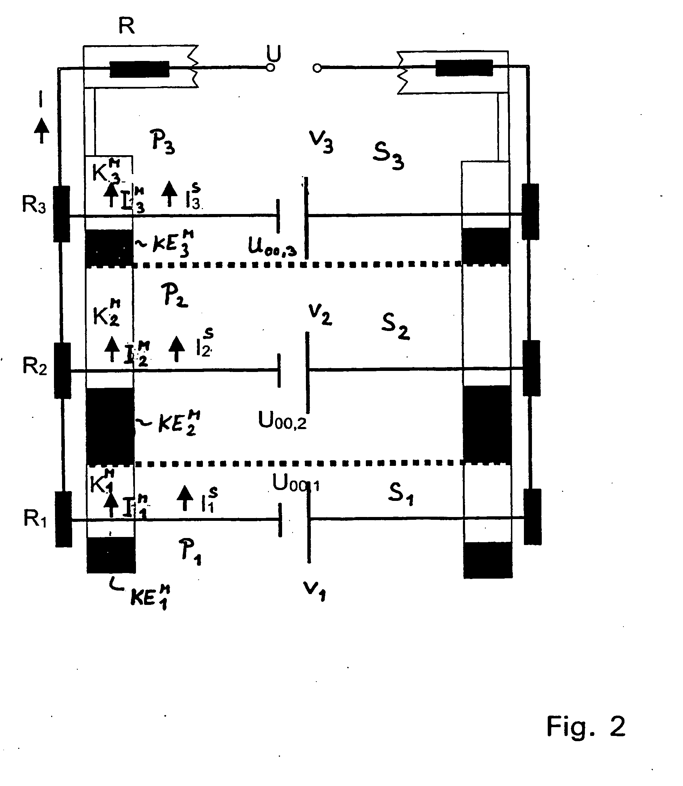

Die Figuren 1 und 2 lassen ein elektrisches Ersatzschaltbild einer Speicherbatterie für den Fall des Ladens und Entladens erkennen, die in drei horizontal übereinander liegende Elektrolytbilanzräume $S_1$, $S_2$ und $S_3$ mit den jeweiligen Elektrolytvolumenanteilen $v_1$, $v_2$ und $v_3$ aufgeteilt ist. Weiterhin ist die Speicherbatterie in derselben horizontalen Einteilung in drei übereinander liegende Elektrodenplatten-Bilanzräume $P_1$, $P_2$ und $P_3$ der Elektrodenplatten aufgeteilt. Hierzu wird die Gesamtspeicherkapazität $K^M$ der Elektrodenplatten der Speicherbatterie in drei Speicherkapazitätsanteile $K_1^M$, $K_2^M$ und $K_3^M$ aufgeteilt. Weiterhin werden den einzelnen Elektrodenplatten-Bilanzräumen $P_1$, $P_2$ und $P_3$ die in diesen Bereichen vorhandenen Gitterwiderstände $R_1$, $R_2$ und $R_3$ der Elektrodenplattengitter zugeordnet. Der Widerstand R stellt den Ableiterwiderstand dar.

Bei der Einteilung der Elektrolytbilanzräume $S_i$ und Elektrodenplatten-Bilanzräume $P_k$, mit i = 1 bis 3 und k = 1 bis 3, gilt, dass nur der Elektrodenplatten-Bilanzraum $P_1$ mit dem Elektrolytbilanzraum $S_1$ in Verbindung steht. Entsprechend steht nur der Elektrodenplatten-Bilanzraum $P_2$ mit dem Elektrolytbilanzraum $S_2$ und der Elektrodenplatten-Bilanzraum $P_3$ mit dem Elektrolytbilanzraum $S_3$ in Verbindung.

Weiterhin ist erkennbar, dass jedem der zugeordneten Elektrolyt- und Elektrodenplattenbilanzräume $S_i$, $P_k$ ein Lade- bzw. Entladestrom $I_1$, $I_2$ und $I_3$ zugeordnet werden kann, deren Summe dem an den Anschlussklemmen der Speicherbatterie fließenden Gesamtstrom I entspricht. Dieser Gesamtstrom I sowie die Klemmenspannung U der Speicherbatterie kann sehr einfach während der Lebensdauer der Speicherbatterie gemessen und als Eingangsgröße zur Bestimmung der Kenngrößen für elektrische Zustände der Speicherbatterie genutzt werden.

Die Figuren 1 und 2 lassen weiterhin erkennen, dass dem Elektrodenplatten-Bilanzraum $P_k$ jeweils Ladungsmengen $KE_k^M$ ( entnommen werden können, die maximal den Wert des jeweiligen Speicherkapazitätsanteils $K_k^M$ annehmen können.

Für den Fall einer Ladung der Speicherbatterie erfolgt, wie in der Figur 1 skizziert, die Verteilung des Gesamtstroms I in Laderichtung für die Elektrolytbilanzräume $S_i$ und Elektrodenplattenbilanzräume $P_K$ separat. Dies ist dadurch begründet, dass durch das Herabsinken der höher konzentrierten Schwefelsäure in der Speicherbatterie nach unten eine zusätzliche Ladung der Elektrolytvolumenanteile $v_1$, $v_2$ in den unten liegenden Elektrolytbilanzräumen $S_1$, $S_2$ entsteht. Dies kann mathematisch als ein zusätzlicher Stromfluss betrachtet werden. Der Einfachheit halber wird dieser Effekt so behandelt, als ob die Elektrolytbilanzräume $S_i$ mit einem anderen Ladestrom $I_i^S$ beaufschlagt werden.

Für die Elektrolytbilanzräume $S_i$ werden die Ladestromanteile I $I_i^S$ wie folgt berechnet:

$$I_i^S = \frac{q_i}{\sum\limits_{n=1}^{N} q_n} \cdot I$$

$$I_N^S = I - \sum\limits_{n=1}^{N-1} I_n^S$$

wobei N die Anzahl der Elektrolytbilanzräume ist und q Teilungsfaktoren sind.

Für die beispielhaft dargestellten drei Elektrolytbilanzräume $S_1$, $S_2$ und $S_3$ ergibt sich folgendes Gleichungs-system:

$$I_1^S = \frac{q_1}{(q_1 + q_2 + q_3)} \cdot I$$

$$I_2^S = \frac{q_2}{(q_1 + q_2 + q_3)} \cdot I$$

$$I_3^S = I - I_1^S - I_2^S$$

Für die Teilungsfaktoren $q_i$ gelten folgende Gleichungen:

$$q_1 = c_1 \cdot (r_L - r_1) \cdot \max\left(\frac{KE_3^M}{K_3^M}, \frac{KE_2^M}{K_2^M}, \frac{KE_1^M}{K_1^M}\right)$$

$$q_2 = c_2 \cdot (r_L - r_2) \cdot \max\left(\frac{KE_3^M}{K_3^M}, \frac{KE_2^M}{K_2^M}\right)$$

$$q_3 = c_3 \cdot (r_L - r_3) \cdot \left(\frac{KE_3^M}{K_3^M}\right)$$

Die Größen $c_1$ bis $c_3$ sind empirische Konstanten, die mit Versuchen für einen jeweiligen Speicherbatterietyp ermittelt werden müssen. Die Größe $r_L$ ist die Säuredichte, die bei der Ladung an den Elektrodenplatten gebildet wird. Sie wird vereinfacht als Konstante angenommen. Ein typischer Wert ist 1,46 g/cm$^3$.

Die Werte $r_1$ bis $r_3$ sind die Elektrolytkonzentrationen in den Elektrolytbilanzräumen $S_1$, $S_2$ und $S_3$. Die Werte

$(KE_k^M)$ sind die dem jeweiligen Elektrodenplatten-Bilanzraum $P_k$ entnommenen Ladungsmengen, die maximal den Wert der bei der Einteilung der Speicherbatterie festgelegten Speicherkapazitätsanteile $K_k^M$ annehmen können.

Die entnommenen Ladungsmengen $KE_k^M$ werden für einen betrachteten Zeitraum dt um den in dem Zeitraum dt integrierten Stromanteil $I_k^M$ des jeweiligen Elekrodenplatten-Bilanzraums $P_k$ vermindert. Wenn der Stromanteil $I_k^M$ für den Zeitraum dt konstant angenommen wird, ergibt sich als Wert für die entnommene Ladungsmenge $KE_k^M$:

$$KE_k^M (t_1+dt) = KE_k^M (t_1) + I_k^M \cdot dt$$

wobei $t_1$ der Beginn des Zeitraums dt ist. Im Anfangszustand nach erstmaliger Inbetriebnahme der Speicherbatterie berechnet sich die entnommene Ladungsmenge zu

$$KE_k^M (t_0) = K_k^M + I_k^M \cdot dt.$$

Diese Stromanteile $I_k^M$ für die Elektrodenplatten-Bilanzräume $P_k$, d. h. die in den Elektrodenplatten bzw. aktiven Massen fließenden Ströme werden wie folgt beschrieben:

$$I_k^M = \frac{d_k^L}{\sum\limits_{n=1}^{N-1} d_n^L} \cdot I$$

und

$$I_N^M = I - \sum\limits_{n=1}^{N-1} I_n^M$$

wobei N die Anzahl der Elektrodenplatten-Säurebilanzräume $P_k$ ist und $d_n^L$ Teilungsfaktoren sind.

Für drei Elektrodenplatten-Bilanzräume $P_1$, $P_2$, $P_3$ ergibt sich folgendes Gleichungssystem:

$$I_1^M = \frac{d_1^L}{d_1^L + d_2^L + d_3^L} \cdot I$$

$$I_2^M = \frac{d_2^L}{d_1^L + d_2^L + d_3^L} \cdot I$$

$$I_3^M = I - I_1^M - I_2^M.$$

Dabei sind die Teilungsfaktoren $d_k^L$ wie folgt:

$$d_1^L = \frac{U_{00,1} - U}{R_1/2 + R_2 + R_3 + R} \cdot f_L\left(KE_1^M, K_1^M\right)$$

$$d_2^L = \frac{U_{00,2} - U}{R_2/2 + R_3 + R} \cdot f_L\left(KE_2^M, K_2^M\right)$$

$$d_3^L = \frac{U_{00,3} - U}{R_3/3 + R} \cdot f_L\left(KE_3^M, K_3^M\right)$$

wobei U die auf eine Zelle bezogene an den Anschlussklemmen der Speicherbatterie gemessene Batteriegesamtspannung ist.

Die Ruhespannungen $U_{oo,k}$ an den jeweiligen Elektrodenplattenbilanzräumen $P_k$ ergeben sich als Funktion der Elektrolytkonzentration $r_i$ in den zugehörigen Elektrolytbilanzräumen $S_i$ und der Batterietemperatur T.

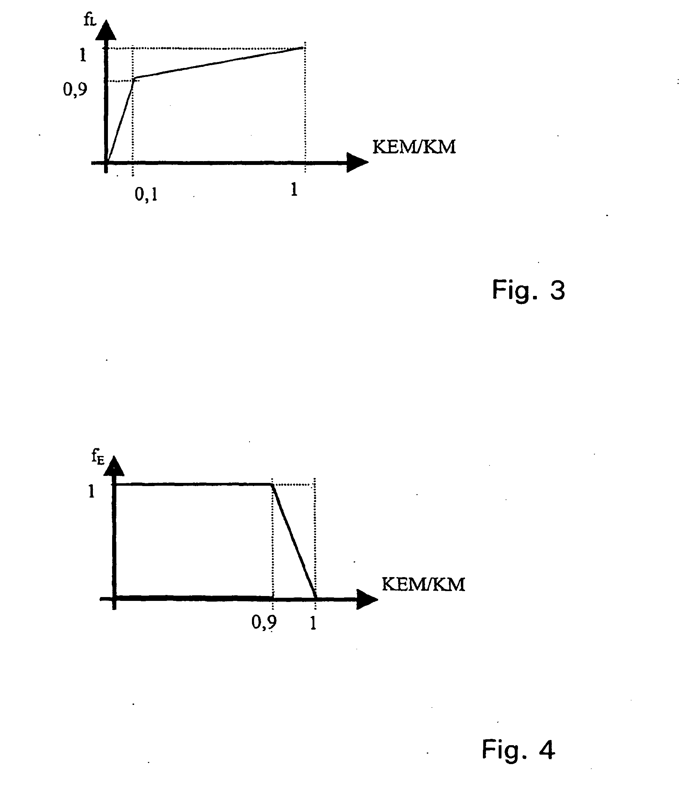

Eine beispielhafte Funktion $f_L$ in Abhängigkeit von der auf den Speicherkapazitätsanteil $K_k^M$ in einem Elektrodenplatten-Bilanzraum $P_k$ bezogenen entnommenen Ladungsmenge $KE_k^M$ ist in der Figur 3 skizziert. Bis zu einem Verhältnis von $KE_k^M$ von 0,1 steigt die Funktion $f_L$ linear stark auf den Wert 0,9 an. Anschließend steigt der Wert der Funktion $f_L$ bis zum Erreichen eines Verhältnisses für $\frac{KE_k^M}{K_k^M} = 1$ langsam linear auf den Wert 1 an.

Für den Fall der Entladung wird der Gesamtstrom I in den Elektrodenplatten-Bilanzräumen $P_k$ in ähnlicher Weise wie oben beschrieben, allerdings mit einer anderen Funktion $f_E$ für die Abhängigkeit von der entnommenen Ladungsmenge $KE_k^M$ und der Speicherkapazitätsanteile $K_k^M$, berechnet:

$$I_1^M = \frac{d_1^E}{d_1^E + d_2^E + d_3^E} \cdot I$$

$$I_2^M = \frac{d_2^E}{d_1^E + d_2^E + d_3^E} \cdot I$$

$$I_3^M = I - I_1^M - I_2^M.$$

Dabei sind die Teilungsfaktoren $d_k^E$ wie folgt:

$$d_1^E = \frac{U_{00,1} - U}{R_1/2 + R_2 + R_3 + R} \cdot f_E\left(KE_1^M, K_1^M\right)$$

$$d_2^E = \frac{U_{00,2} - U}{R_2/2 + R_3 + R} \cdot f_E\left(KE_2^M, K_2^M\right)$$

$$d_3^E = \frac{U_{00,3} - U}{R_3/3 + R} \cdot f_E\left(KE_3^M, K_3^M\right).$$

Die Werte für die entnommenen Ladungsmengen $KE_k^M$ werden wie oben beschrieben durch Reduzierung um den über den Zeitraum dt integrierten Stromanteil $I_k^M$ für die Elektrodenplatten-Bilanzräume $P_k$ berechnet.

Die Funktion $f_E$ in Abhängigkeit von der entnommenen Ladungsmenge $KE_k^M$ bezogen auf den Speicherkapazitätsanteil $K_k^M$ ist beispielhaft in der Figur 4 gezeigt. Der Wert für $f_E$ ist bis zu einem Verhältnis $\frac{KE_k^M}{K_k^M} = 0{,}9$ gleich Eins. Für den Bereich von

$\frac{KE_k^M}{K_k^M} = 0{,}9$ bis 1 fällt der Wert für $f_E$ linear von Eins bis zum Wert Null ab.

Im Falle der Entladung entspricht der Stromanteil $I_i^S$ für die Elektrolytbilanzräume $S_i$ dem Wert des Stromanteils

$I_k^M$ für den zugeordneten Elektrodenplattenbilanzraum $P_k$.

Die Elektrolytkonzentration $r_i$ nach erfolgtem Stromumsatz für einen Elektrolytbilanzraum $S_i$ berechnet sich als Funktion

$$r_i(t_1 + dt) = f\big(r_i(t_1), v_i, I_i^S \cdot dt, T\big).$$

Dabei ist $r_i$ die vor dem Zeitraum dt in dem Elektrolytbilanzraum $S_i$ vorhandene Elektrolytkonzentration, $v_i$ der Elektrolytvolumenanteil in dem Elektrolytbilanzraum $S_i$, T die Temperatur der Speicherbatterie und $I_i^S \cdot dt$ die im Elektrolytbilanzraum $S_i$ umgesetzte Ladung in dem Zeitraum dt.

Als Kenngrößen für Zustände der Speicherbatterie kann beispielsweise die der Speicherbatterie noch entnehmbaren Ladungsmenge berechnet werden, um die Restkapazität der Speicherbatterie abzuschätzen.

Hierzu wird für jeden Elektrodenplatten-Bilanzraum $P_k$ die aus der aktiven Masse noch entnehmbare Ladungsmenge $RK_k^M$ (Restkapazität) berechnet durch:

$$RK_k^M = K_k^M - \big(KE_k^M + I_k^M \cdot dt\big)$$

Anschließend erfolgt die Berechnung der dem entsprechenden Elektrolytbilanzraum $S_i$ entnehmbaren Ladungsmenge $RK_i^S$ in Abhängigkeit von dem Elektrolytvolumen $v_i$ und der aktuellen Säuredichte $r_i$ in dem Elektrolytbilanzraum $S_i$ und der Temperatur T der Speicherbatterie nach der Funktion:

$$RK_i^S = f\big(v_i, r_i, T\big).$$

Die der Speicherbatterie noch entnehmbare Ladungsmenge $RK_g$ wird anhand der entnehmbaren Ladungsmenge $RK_k^M$ in den Elektrodenplatten-Bilanzräumen $P_k$ und der entnehmbaren Ladungsmenge $RK_i^S$ in den Elektrolytbilanzräumen $S_i$ mit folgender Fallunterscheidung errechnet, die notwendig ist, um das "Nachfallen" von Säure höherer Dichte aus einem oberen Bilanzraum in einen unteren Bilanzraum zu berücksichtigen. Dabei wird angenommen, dass eine vollständige Entladung erst im unteren Bereich der Speicherbatterie, dann im mittleren Bereich und zuletzt oben erfolgt.

a) Wenn $RK_1^S < RK_1^M$ ist:

Fehlende Säurekapazität wird dem Elektrolytvolumen $v_2$ maximal solange entnommen bis die Säure im Elektrolytvolumen $v_2$ verbraucht ist. Die Säurekapazität $RK_2^S$ im Elektrolytvolumen $v_2$ wird entsprechend der im Elektrolytvolumen $v_1$ verbrauchten Säure reduziert. Damit wird $RK_1^S$ erhöht.

b) Wenn $RK_2^S < RK_2^M$ ist:

Fehlende Säurekapazität wird dem Elektrolytvolumen $v_3$ maximal solange entnommen, bis die Säure im Elek-

trolytvolumen $v_3$ verbraucht ist. Die Säurekapazität $RK_3^S$ im Elektrolytvolumen $v_3$ wird entsprechend dem Elektrolytvolumen $v_2$ verbrauchten Säure reduziert. Mit Schritt a) kann dann der neue Wert für $RK_2^S$ berechnet werden. Es ergibt sich dann:

$$RK_g = \sum_{k=1}^{N} \min\left(RK_k^S, RK_k^M\right)$$

Als weitere Kenngröße für einen Zustand der Speicherbatterie kann die Ruhespannung $U_{00,g}$ der Speicherbatterie aus den einzelnen Ruhespannungswerten $U_{00,k}$ der Bilanzräume $S_i$, $P_k$ berechnet werden. Dabei muss jedoch noch der Umladestrom $I_U$ von Orten höherer Ruhespannung $U_{00}$ zu Orten niedriger Ruhespannung $U_{00}$ an der gleichen Elektrodenplatte berücksichtigt werden. Dieser Umladestrom $I_U$ entsteht dadurch, dass am Ort hoher Ruhespannung $U_{00}$ das aktive Material entladen wird und am Ort niedrigerer Ruhespannung $U_{00}$ eine Ladung erfolgt. Damit verbunden ist ein Spannungsabfall über den Polarisationswiderstand $R_P$, der den Polarisationswiderstand an der Plattenoberfläche bei kleinen Strömen darstellt, und der einzelnen Gitterwiderstände $R_k$. Dadurch ergibt sich eine Ruhespannung $U_{00}$, deren Wert zwischen den Ruhespannungen $U_{00,k}$ der einzelnen Bilanzräume $S_i$, $P_k$ liegt (Mischpotential).
Der Umladestrom $I_U$ wird wie folgt berechnet:

$$I_U = \left(U_{00,x} - U_{00,y}\right) \cdot \left(R_{P,x} + R_{P,y} + \sum_{n=x}^{y} R_n\right).$$

Die Gesamt-Ruhespannung $U_{00,g}$ der Speicherbatterie berechnet sich wie folgt:

$$U_{00,g} = U_{00,x} - I_U \cdot \left(R_{P,x} + \sum_{n=x}^{y} R_n\right).$$

Gegebenenfalls muss der Umladestrom $I_u$ und die Gesamt-Ruhespannung $U_{00,g}$ auf die Anzahl der Zellen bezogen werden.
Die Indizes x, y für die Ruhespannung $U_{00,x}$, $U_{00,y}$ bezeichnen einen jeweiligen Elektrodenplatten-Bilanzraum $P_k$, wobei eine Fallunterscheidung erfolgt, da ein Umladestrom $I_U$ nur dann fließen kann, wenn der Ort mit der höheren Ruhespannung $U_{00}$ noch entladbare Masse und der mit der niedrigeren Ruhespannung $U_{00}$ noch aufladbare Masse hat. Die Fallunterscheidung ist wie folgt:

a) $K_1^M$ ist teilgeladen oder vollgeladen, $K_3^M$ ist teilgeladen oder entladen, $K_2^M$ egal:

$$X=1, Y=3$$

$$R_i = R_1/2 + R_2 + R_3/2$$

b) $K_1^M$ ist teilgeladen oder vollgeladen, $K_2^M$ ist teilgeladen oder entladen, $K_3^M$ vollgeladen:

$$X=1, Y=2$$

$$R_i = R_1/2 + R_2/2$$

c) $K_2^M$ ist teilgeladen oder vollgeladen, $K_3^M$ ist teilgeladen oder entladen, $K_1^m$ ist entladen:

$$X=2, \quad Y=3$$

$$R_i=R_2/2+R_3/2$$

d) $K_1^M$ ist vollgeladen oder teilgeladen, $K_2^M$ und $K_3^M$ sind vollgeladen:

$$U_{00,g}=U_{00,1}$$

e) $K_2^M$ ist vollgeladen oder teilgeladen, $K_1^M$ ist entladen, $K_3^M$ ist vollgeladen

$$U_{00,g}=U_{00,2}$$

f) alle sonstigen Fälle:

$$U_{00,g}=U_{00,3}.$$

Als Kenngröße kann zudem die Eisbildung berechnet und bewertet werden. Dies ist durch Betrachtung einzelner Elektrolytbilanzräume $S_i$ und Berechnung der Säuredichte $r_i$ in diesen Elektrolytbilanzräumen $S_i$ für unterschiedliche Zonen möglich. Anhand der Temperatur T und der Elektrolytkonzentration $r_i$ kann ausgerechnet werden, welches Volumen an Eiskristallen sich in den einzelnen Elektrolytbilanzräumen $S_i$ bildet.

Zu jeder Temperatur T gehört eine Gleichgewichtskonzentration CGG der im Elektrolyt vorhandenen Schwefelsäure. Wird diese unterschritten, so friert reines Wasser aus und es bilden sich Eiskristalle, solange bis sich im Rest der flüssigen Phase des Elektrolyten diese Gleichgewichtskonzentration CGG eingestellt hat. Das Volumen an Eiskristallen errechnet sich dann ohne Berücksichtigung der Volumenausdehnung des Wassers wie folgt:

$$v_{Eis,i}=(1-C_i/CGG_i) \cdot v_i,$$

wobei die Gleichgewichtskonzentration CGG eine definierte Funktion von der Temperatur im jeweiligen Elektrolytbilanzraum $S_i$ ist:

$$CGG_i=f(T_i).$$

$C_i$ ist die Konzentration an Schwefelsäure im Elektrolytvolumen $v_i$ und kann aus der Elektrolytkonzentration $r_i$ und der Temperatur $T_i$ im jeweiligen Elektrolytbilanzraum $S_i$ errechnet werden.

Mit der Information über das Eisvolumen $v_{Eis}$ in jedem Elektrolytbilanzraum $S_i$ kann dann eine Aussage getroffen werden, ob durch die Eiskristalle die Speicherbatterie in ihrer Leistungsfähigkeit beeinträchtigt wird. Dies kann z. B. so erfolgen, dass bei Auftreten von Eiskristallen nur im obersten Elektrolytbilanzraum $S_i$ die volle Leistungsfähigkeit der Batterie angenommen wird. Hingegen wird bei Auftreten von Eiskristallen im untersten Elektrolytbilanzraum $S_i$ die Speicherbatterie als nicht mehr leistungsfähig angesehen.

Dabei können eine oder mehrere Parameter und/oder Zustandsgrößen des Batteriemodells mittels eines Parameter- und/oder Zustandsschätzverfahrens durch Anpassung der Modellergebnisse ermittelt werden.

Z. B. kann eine Adaption der Säuredichte $r_i$ an Messwerte erfolgen. Durch die Berechnung der Ruhespannung $U_{00,g}$ in dem Modell und durch den Vergleich mit der tatsächlichen Ruhespannung $U_{00,g}$, die von anderen Verfahren bereitgestellt oder durch Abwarten einer langen Ruhepause ermittelt werden kann, existiert eine Möglichkeit, eine Aussage zu treffen, wie gut das Modell den derzeitigen Batteriezustand abbildet. So kann z. B. durch Bewegung der Batterie eine Mischung der Säure erfolgen, die das Modell nicht berücksichtigen kann, da nur Strom und Spannung gemessen werden. In derartigen Fällen ist es dann nötig, dass eine Anpassung vorgenommen wird. Diese erfolgt anhand der Differenz zwischen der im Modell berechneten Ruhespannung $U_{00,g}$ durch eine Anpassung der Elektrolyttzozotrtone $r_i$ in den Elektrolytbilanzräumen $S_l$ wie folgt:

Wenn z. B. die Differenz zwischen der gemessenen und der aus dem Modell berechneten Ruhespannung negativ ist und die Ruhespannung $U_{00,g}$ alleine durch die Säuredichte $r_l$ im mittleren Bilanzraum $S_2$ bei einem Modell mit drei Elektrolytbitanzräumen $S_i$ bestimmt ist, so wird die Säuredichte $r_i$ in dem zweiten Bilanzraum $S_i$ erniedrigt. Die Elektrolytkonzentration $r_i$ in den anderen Bilanzräumen $S_1$, $S_3$ müssten entsprechend der Randbedingungen

 a) Säuremenge bleibt konstant

 b) Elektrolytkonzentration $r_l$ von oben nach unten monoton an

 c) bestimmte Grenzwerte werden nicht unter- oder überschritten angepasst werden.

Das Verfahren wurde anhand eines realen Experimentes mit Messungen an einer 110 Ah Batterie verifiziert. Dabei wurde die Batterie nach und nach stärker in Säureschichtung gebracht. Die Versuchsdurchführung bestand aus stufenweiser Ladung und Entladung, wobei der Versuch im entladenen Zustand startete. Zwischendurch wurde die Speicherbatterie soweit entladen, bis die Entladeschlussspannung von 10,5 Volt erreicht war.

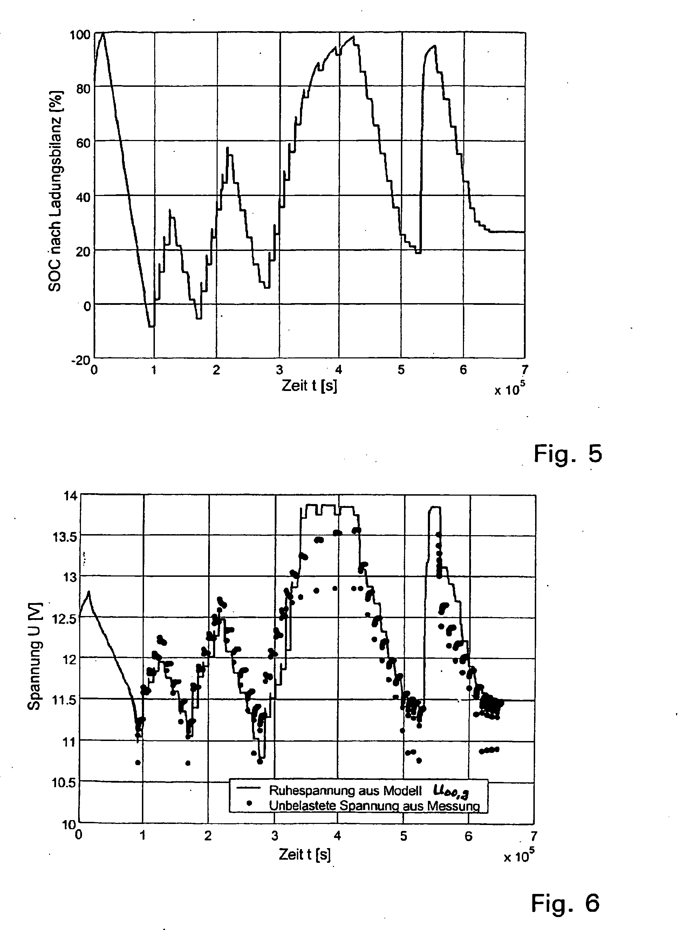

In den Figuren 5 bis 10 sind die Versuchs- und Vergleichsdaten über die Beobachtungszeit t aufgetragen.

Die Figur 5 zeigt den Ladezustand SOC, der durch Berechnung des Ladedurchsatzes bestimmt wurde. Es ist zu erkennen, dass die Speicherbatterie in Zyklen entladen und geladen wurde. Die Entladezyklen sind durch den abfallenden Ladezustand SOC und die Ladezyklen durch den ansteigenden Ladezustand SOC zu erkennen.

Die Figur 6 lässt einen Vergleich der gemessenen unbelasteten Klemmenspannung U der Speicherbatterie bei Null-Strom (I=0) und der aus dem oben beschriebenen Modell berechneten Ruhespannung $U_{00,g}$ erkennen. Die gemessene unbelastete Spannung U ist durch die Punkte symbolisiert.

Da die bei Null-Strom gemessene unbelastete Spannung U noch nicht die Ruhespannung $U_{oo}$ darstellt, die sich erst nach mehreren Stunden Ruhephase einstellt, sind die ersten Messwerte in der Ruhephase unterschiedlich zu den anderen Werten. Es ist trotzdem eine gute Übereinstimmung zwischen der Messung und der aus dem Modell berechneten Ruhespannung zu sehen.

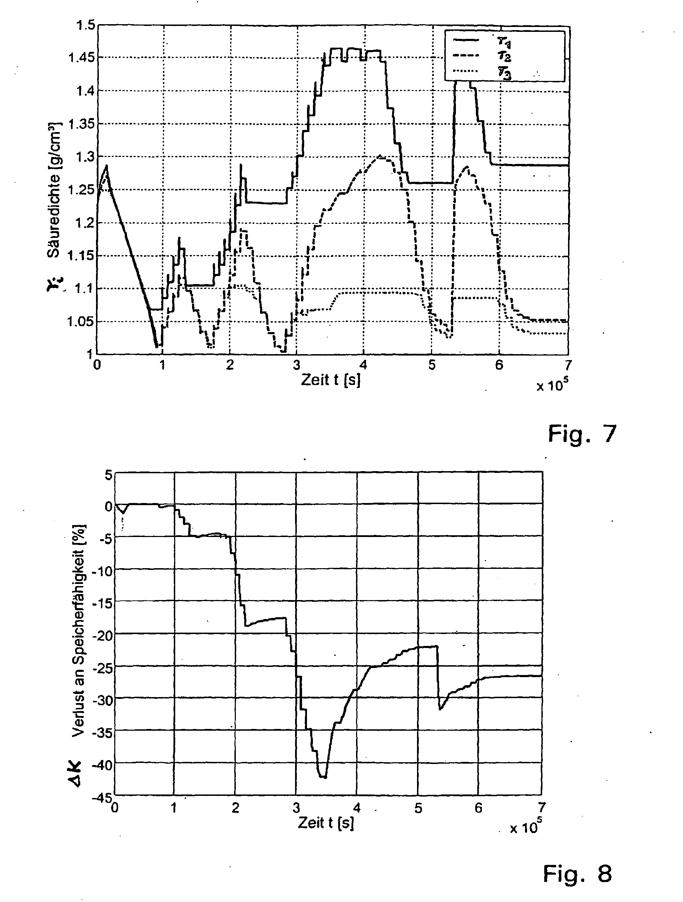

Die Figur 7 lässt die für die drei Elektrolytbilanzräume $S_1$, $S_2$ und $S_3$ berechneten Elektrolytkonzentrationen $r_1$, $r_2$ und $r_3$ über die Zeit erkennen. Es wird deutlich, dass die Säuredichte im unteren Bereich, d. h. im Elektrolytbilanzraum $S_1$ in der Ladephase stärker zunimmt, als in den darüberliegenden Elektrolytbilanzräumen $S_2$ und $S_3$.

Die Figur 8 lässt den Verlust an Speicherkapazität $\Delta K$ für den theoretischen Fall der Vollladung erkennen. Damit kann zu jedem Zeitpunkt t aus der Speicherkapazität K der Speicherbatterie im Neuzustand die verbleibende Speicherkapazität bestimmt werden.

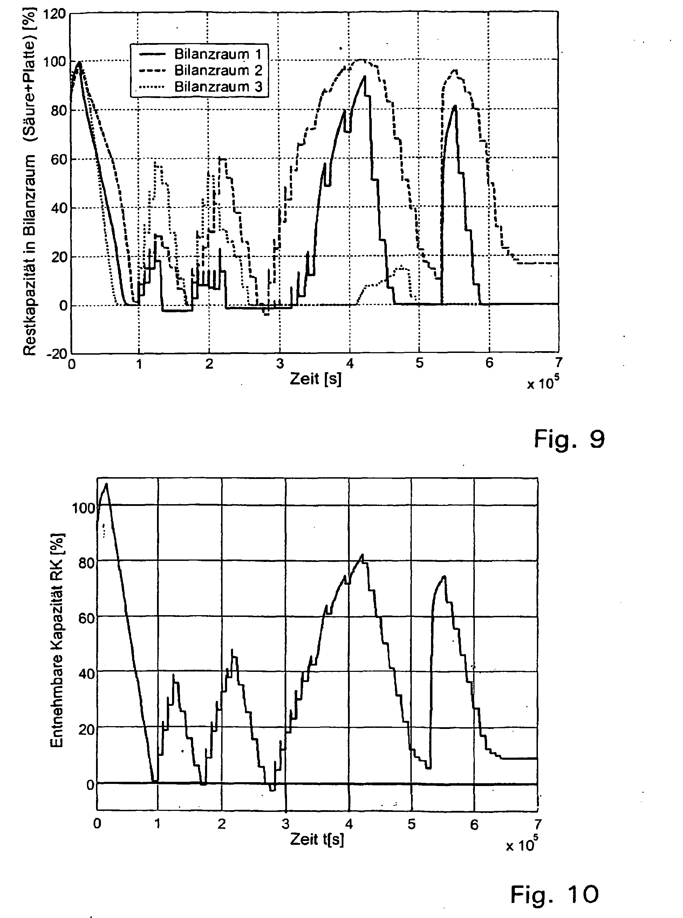

Die Figur 9 lässt die in den einzelnen Elektrodenplatten-Bilanzräumen $P_k$ noch vorhandene Restkapazität $RK_k$ über die Zeit t erkennen. Es wird deutlich, dass vor allem der Elektrolytbilanzraum $S_3$ und Elektrodenplatten-Bilanzraum $P_3$ den Verlust an Speicherkapazität im Wesentlichen bestimmt, da hier praktisch keine Säure nach der Entladung der Bilanzräume $S_1$, $S_2$ und $P_1$, $P_2$ vorhanden ist.

Die Figur 10 lässt die entnehmbare Speicherkapazität $RK_g$ als Kenngröße für den Zustand der Speicherbatterie erkennen, die aus dem oben beschriebenen Modell über die Zeit berechnet wurde. Im Idealfall, wenn das beschriebene Verfahren perfekt funktioniert, enden alle Entladevorgänge auf der Nulllinie. Es ist zu sehen, dass nur gegen Ende des Versuches ein Fehler von etwa 10 % * $RK_g$ vorliegt. Somit liegt eine gute Übereinstimmung zwischen dem Modell und der Messung vor.

Weiterhin können von den gemessenen und errechneten Größen abgeleitet, das Hochstromverhalten und andere Kenngrößen vorhergesagt werden.

## Patentansprüche

**1.** Verfahren zur Bestimmung der Restkapazität, die einer Speicherbatterie noch entnommen werden kann mit den Schritten:

 a) Einteilen des Elektrolytvolumens (v) der Speicherbatterie in mindestens zwei horizontal übereinander liegende Elektrolytvolumenanteile ($v_i$) mit zugeordneten horizontal übereinander liegenden Elektrolytbilanzräumen ($S_i$);

b) Festlegen von mindestens zwei in derselben horizontalen Einteilung wie die Elektrolytbilanzräume ($S_i$) übereinander liegenden Elektrodenplatten-Bilanzräumen (Pk) und Zuordnung der in den Bereichen der Elektrodenplatten-Bilanzräume vorhandenen Gitterwiederstände $\left(R_k^M\right)$ der Elektrodenplattengitter zu den Elektrodenplatten-Bilanzräumen ($P_k$) und Aufteilen der Gesamtspeicherkapazität ($K^M$) der Elektrodenplatten der Speicherbatterie in Speicherkapazitätsanteile $\left(K_k^M\right)$ für die festgelegten Elektrodenplatten-Bilanzräume ($P_k$), wobei jeweils ein Elektrodenplatten-Bilanzraum mit einem zugeordneten Elektrolytbilanzraum in Verbindung steht, nicht hingegen mit anderen Elektrolytbilanzräumen;

c) Bestimmen der Elektrolytkonzentrationen ($r_i$) der Elektrolytvolumenanteile ($v_i$) für die festgelegten Elektrolytbilanzräume ($S_i$);

d) Bestimmen der in den Elektrodenplatten der Elektrodenplatten-Bilanzräume ($P_k$) jeweils umgesetzten Ladungsmengen $\left(KE_k^M\right);$ und

e) Messen des an den Anschlussklemmen der Speicherbatterie fließenden Gesamtstroms (I), der Klemmenspannung (U) der Speicherbatterie und der Batterietemperatur (T); **gekennzeichnet durch** die Schritte:

f) Berechnen der den Elektrolytvolumenanteilen ($v_i$) in den einzelnen Elektrolytbilanzräumen ($S_i$) noch entnehmbaren Ladungsmengen $\left(RK_i^S\right)$ in Abhängigkeit von der aktuellen Elektrolytkonzentration ($r_i$) und dem Elektrolytvolumen ($v_i$) in dem jeweiligen Elektrolpbilanzraum ($S_i$) und der Batterietemperatur (T) mit einem mathematischen Modell zur Beschreibung eines elektrischen Ersatzschaltbildes mindestens mit den Grössen der Gitterwiderstände der Elektrodenplattengitter $\left(R_k^M\right)$ für die festgelegten Elektrodenplatten-Bilanzräume ($P_k$) aus Schritt b), der Speicherkapazitätsanteile $\left(K_k^M\right),$ der im Schritt c) bestimmten Elektrolytkonzentrationen ($r_i$) der Elektrolytvolumenanteile ($V_i$), der im Schritt d) bestimmten umgesetzten Ladungsmengen $\left(KE_k^M\right)$ und dem im Schritt e) gemessenen Gesamtstrom (I) und Klemmenspannung (U) als Eingangsgrößen;

g) Berechnen der Ladungsmengen $\left(RK_k^M\right),$ die den aktiven Massen der jeweiligen Elektrodenplatten-Bilanzräume ($P_k$) noch entnehmbar sind,

h) Berechnen der Restkapazität ($RK_g$), die der Speicherbatterie noch entnommen werden kann, als Kenngröße in Abhängigkeit von den für die Elektrodenplatten-Bilanzräume ($P_k$) bestimmten Ladungsmengen $\left(RK_k^M\right)$ und den für die Elektrolytbilanzräume ($S_i$) bestimmten Ladungsmengen $\left(RK_i^S\right),$ die den Elektrolytvolumenanteilen ($v_i$) in den jeweiligen Elektrolytbilanzräumen ($S_i$) noch entnehmbar sind.

2. Verfahren nach Anspruch 1, **dadurch gekennzeichnet, dass** die Säuredichte der Elektrolytvolumenanteile ($v_i$) eine Maßzahl für die Elektrolytkonzentration ist.

3. Verfahren nach einem der Ansprüche 1 bis 2, **gekennzeichnet durch** Bestimmen der Ruhespannungen ($U_{00k}$) in den festgelegten Elektrodenplatten-Bilanzräumen ($P_k$) in Abhängigkeit von der Elektrolytkonzentration ($r_i$) in einem zugeordneten Elektrolytbilanzraum ($S_i$).

4. Verfahren nach Anspruch 3, **gekennzeichnet durch** Bestimmen der Ruhespannungen ($U_{00k}$) in den im Schritt b) festgelegen Elektrodenplatten-Bilanzräumen ($P_k$) weiterhin in Abhängigkeit von der gemessenen Batterietemperatur (T) und der im Schritt d) bestimmten umgesetzten Ladungsmengen $\left(KE_k^M\right).$

5. Verfahren nach einem der vorhergehenden Ansprüche, **gekennzeichnet durch** Berechnen der Ströme ($I_i$) für die Elektrolytbilanzräume ($S_i$) aus dem an den Anschlussklemmen der Speicherbatterie fließenden Gesamtstrom (I) und einem von der Elektrolytkonzentration ($r_i$) in dem jeweiligen Elektrolytbilanzraum ($S_i$) abhängigen Teilungsverhältnis.

**6.** Verfahren nach einem der vorhergehenden Ansprüche, **gekennzeichnet durch** Berechnen der Ströme ($I_k$) für die Elektrodenplatten-Bilanzräume ($P_k$) aus dem an den Anschlussklemmen der Speicherbatterie fließenden Gesamtstrom (I) und einem von der Ruhespannung ($U_{00k}$) in den jeweiligen Elektrodenplatten-Bilanzraum ($P_k$) und den Widerstandsanteilen $(R_k^M)$ abhängigen Teilungsverhältnis.

**7.** Verfahren nach Anspruch 6, **dadurch gekennzeichnet, dass** für die Entladeströme die Ströme ($I_i$) für die Elektrolytbilanzräume ($S_i$) gleich den für die zugeordneten Elektrodenplatten-Bilanzräume ($P_k$) berechneten Ströme ($I_k$) angenommen werden.

**8.** Verfahren nach einem der vorhergehenden Ansprüche, **gekennzeichnet durch** Berechnen der nach einem Zeitraum (dt) in einem ElektrodenplattenBilanzraum ($P_k$) umgesetzten Ladungsmenge $(KE_k^M)$ aus der bis unmittelbar vor diesem Zeitraum umgesetzten Speicherkapazität $(KE_k^M)$ in diesem Elektrodenplatten-Bilanzraum ($P_k$) und der in dem Zeitraum (dt) **durch** den Elektrodenplatten-Bilanzraum ($P_k$) geflossenen Ladung $(I_k^M \cdot x \, dt)$:

$$KE_k^M (t_1+dt)= KE_k^M (t_1) + I_k^M \cdot dt.$$

**9.** Verfahren nach einem der vorhergehenden Ansprüche, **gekennzeichnet durch** Berechnen der den Elektrodenplatten in den einzelnen Elektrodenplatten-Bilanzräumen ($P_k$) noch entnehmbaren Ladungsmenge $(RK_k^M)$ aus dem Speicherkapazitätsanteil $(K_k^M)$ des jeweiligen Elektrodenplatten-Bilanzraumes ($P_k$) vermindert um die bis zum Zeitraum (dt) der aktiven Masse in dem Elektrodenplatten-Bilanzraum ($P_k$) entnommenen Ladungsmenge $(KE_k^M)$ und vermindert um die in dem Zeitraum (dt) den Elektrodenplatten in dem Elektrodenplatten-Bilanzraum ($P_k$) entnommenen Ladung $(I_k^M \cdot x \, dt)$.

**10.** Verfahren nach einem der vorhergehenden Ansprüche, **gekennzeichnet durch** Bestimmen der Restkapazität in Abhängigkeit von dem Umladestrom ($I_U$) an den Elektrodenplatten zwischen Orten höherer Ruhespannung ($U_{00,x}$) und Orten niedrigerer Ruhespannung ($U_{00,y}$), wobei der Umladestrom ($I_U$) aus dem Polarisationswiderstand ($R_P$) an den Elektrodenplattenoberflächen und der Summe der Gitterwiderstände ($R_n$) zwischen den Orten (x, y) nach der Formel:

$$I_U = \left(U_{00,x} - U_{00,y}\right) \cdot \left(R_{P,x} + R_{P,y} + \sum_{n=x}^{y} R_n\right)$$

berechnet wird.

**11.** Verfahren nach einem der vorhergehenden Ansprüche, **gekennzeichnet durch** Berechnen der Ruhespannung ($U_{00,g}$) der Speicherbatterie als Kenngröße als Funktion des Ladungszustandes der einzelnen Elektrodenplatten-Bilanzräume ($P_k$), der Ruhespannungen ($U_{00,k}$) in den Elektrodenplatten-Bilanzräumen ($P_k$), der Widerstandsanteile $(R_k^M)$, des Polarisationswiderstandes ($R_p$) und des Umladestroms ($I_U$) **durch** Umladung an jeweils einer einzelnen Elektrodenplatte.

**12.** Verfahren nach einem der vorhergehenden Ansprüche, **gekennzeichnet durch** Ermitteln des Eiskristallvolumens ($v_{Eis}$) in den Elektrolytbilanzräumen ($S_i$) aus einem definierten Zusammenhang zwischen der Gleichgewichtskonzentration ($CGG_i$) der Säure im Elektrolyten und der Temperatur (T) sowie der Säurekonzentration ($C_i$) im Elektrolyten nach der Formel:

$$v_{Eis,l} = (1 - C_l/CGG_l) \cdot v_l.$$

**13.** Verfahren nach Anspruch 12, **gekennzeichnet durch** Ermitteln einer Kenngröße für die Leistungsfähigkeit der Speicherbatterie in Abhängigkeit von dem Anteil des Eiskristallvolumens ($v_{Eis}$) am Elektrolytvolumen ($v_l$) in den Elektrolytbilanzräumen ($S_l$) und dem Ort ($S_l$) des Auftretens der Eiskristallbildung.

**14.** Verfahren nach einem der vorhergehenden Ansprüche, **gekennzeichnet durch** Anlassen der Zustandswerte für die Elektrolytkonzentration ($r_l$) in den Elektrolytbilanzräumen ($S_l$) in Abhängigkeit von der Differenz zwischen der tatsächlichen Ruhespannung ($U_{00}$) und der berechneten Ruhespannung ($U_{00,g}$).

**15.** Überwachungseinrichtung für eine elektrochemische Speicherbatterie mit einer Messeinheit zur Messung der Batterieklemmenspannung (U), des Batterieklemmenstroms (I) und der Batterietemperatur (T), und mit einer Auswerteeinheit, **dadurch gekennzeichnet, dass** die Auswerteeinheit zur Durchführung des Verfahrens nach einem der vorhergehenden Ansprüche durch Programmierung einer Mikroprozessoreinheit ausgebildet ist.

**Claims**

**1.** Method for determination of the remaining capacity which can still be drawn from an energy storage battery, having the following steps:

(a) Subdividing the electrolyte volume (v) of the energy storage battery into at least two electrolyte volume components ($v_l$), which are located horizontally one above the other, with associated electrolyte balancing areas ($S_l$);

(b) Defining of at least two electrode plate balancing areas ($P_k$) in the same horizontal arrangement as the electrolyte balancing areas ($S_i$), associating the grid resistances ($R_k^M$) of the electrode plate grids in the areas of the electrode plate balancing areas to the electrode plate balancing areas ($P_K$), and dividing the total energy storage capacity ($K^M$) of the electrode plates of the energy storage battery into energy storage capacity components ($K_k^M$) for the defined electrode plate balancing areas ($P_k$), where each of the electrode plate balancing areas is connected to one associated electrolyte balancing area, but not connected to other electrolyte balancing areas;

(c) Determining of the electrolyte concentration ($r_i$) of the electrolyte volume components ($v_i$) for the defined electrolyte balancing areas ($S_i$);

(d) Determining of the amounts of charge ($KE_k^M$) which are in each case permuted in the electrode plate balancing areas ($P_k$);

(e) Measuring of the total current (I) through the connecting terminals of the energy storage battery, of the terminal voltage (U) of the energy storage battery and of the battery temperature (T); **characterized by** the steps:

(f) Determining of amounts of charge ($RK_i^S$), which can still be drawn from the electrolyte volume components ($v_l$) in the associated electrolyte balancing areas ($S_i$), in dependence of the actual electrolyte concentration ($r_l$) and the electrolyte volume ($v_i$) in the associated electrolyte balancing area ($S_l$) and the battery temperature (T) by means of a mathematical model for describing an electrical equivalent circuit at least by means of the variables of the grid resistances of the electrode plate grids ($R_k^M$) for the defined electrode plate balancing areas ($P_k$) of step b), of the energy storage capacity components ($K_k^M$), of the electrolyte concentration ($r_i$), of the electrolyte volume components ($v_i$) as determined in step c), of the amounts of charge ($KE_k^M$) permuted as determined in

**16**

step d) and of the total current (I) and terminal voltage (U) as measured in step e) as input variables;

(g) Calculating of the amounts of charge $(RK_k^M)$ which can still be drawn from the active masses of the respective electrode plate balancing areas ($P_k$);

(h) Calculating the remaining capacity ($RK_g$) which can still be drawn from the energy storage battery as a characteristic variable as a function of the amounts of charge $(RK_k^M)$ which have been determined for the electrolyte balancing areas ($P_k$) and as a function of the amounts of charge $(RK_i^S)$ which have been determined for the electrolyte balancing areas ($S_i$) and can still be drawn from the electrolyte volume components ($v_i$) in the respective electrolyte balancing areas ($S_l$).

2. Method according to claim 1, **characterized in that** the acid density of the electrolyte volume components ($v_l$) is a measure of the electrolyte concentration.

3. Method according to claim 1 or 2, **characterized by** the rest voltages ($U_{00k}$) being determined in the defined electrode plate balancing areas ($P_k$) as a function of the electrolyte concentration ($r_l$) in an associated electrolyte balancing area ($S_l$).

4. Method according to claim 3, **characterized by** the rest voltages ($U_{00k}$) also being determined in the defined electrode plate balancing areas ($P_k$) of step b) as a function of the battery temperature (T) and of the amounts of charge $(KE_k^M)$ permuted as determined in step d).

5. Method according to one of the preceding claims, **characterized by** the currents ($I_i$) for the electrolyte balancing areas ($S_i$) being calculated from the total current (I) flowing through the connecting terminals of the energy storage battery and from a division ratio which is dependent on the electrolyte concentration ($r_i$) in the respective electrolyte balancing area ($S_i$).

6. Method according to one of the preceding claims, **characterized by** the currents ($I_k$) for the electrode plate balancing areas ($P_k$) being calculated from the total current (I) flowing through the connecting terminals of the energy storage battery and from a division ratio which is dependent on the rest voltage ($U_{00K}$) in the respective electrode plate balancing area ($P_k$) and the resistance components $(R_k^M)$.

7. Method according to claim 6, **characterized in that,** for the discharge currents, the currents ($I_j$) for the electrolyte balancing areas ($S_l$) are assumed to be equal to the currents ($I_k$) calculated for the associated electrode plate balancing areas ($P_k$).

8. Method according to one of the preceding claims, **characterized by** the amount of charge $(KE_k^M)$ permuted in an electrode plate balancing area ($P_k$) after a time period (dt) being calculated from the energy storage capacity $(KE_k^M)$ permuted in this electrode plate balancing area ($P_k$) until immediately before this time period and the charge $(I_k^M \times dt)$ which has flowed through the electrode plate balancing area ($P_k$) in the time period (dt):

$$KE_k^M(t_1 + dt) = KE_k^M(t_1) + I_k^M * dt .$$

9. Method according to one of the preceding claims, **characterized by** the amount of charge $(RK_k^M)$ ' which can still be drawn from the electrode plates in the individual electrode plate balancing areas ($P_k$) being calculated from the energy storage capacity component $(K_k^M)$ of the respective electrode plate balancing areas ($P_k$) minus the amount of charge $(KE_k^M)$ which was drawn from the active mass in the electrode palte balancing area ($P_k$) prior to the time period (dt), and minus the charge $(I_k^M \times dt)$ drawn from the electrode plates in the electrode plate balancing area ($P_k$) in the time period (dt).

**10.** Method according to one of the preceding claims, **characterized by** the remaining capacity being determined as a function of the charge reversal current ($I_u$) on the electrode plates between points where the rest voltage ($U_{00,x}$) is relatively high and points where the rest voltage ($U_{00,y}$) is relatively low, with the charge reversal current ($I_U$) being calculated from the polarization resistance ($R_p$) on the electrode plate surfaces and the sum of the grid resistances ($R_n$) between the points (x, y), using the formula:

$$I_U = \left(U_{00,x} - U_{00,y}\right) * \left( R_{P,x} + R_{P,y} + \sum_{n=x}^{y} R_n \right)$$

**11.** Method according to one of the preceding claims, **characterized by** the rest voltage ($U_{00,g}$) of the energy storage battery being calculated as a characteristic variable as a function of the state of charge of the individual electrode plate balancing areas ($P_k$), of the rest voltages ($U_{00,k}$) in the electrode plate balancing areas ($P_k$), of the resistance components ($R_k^M$), of the polarization resistance ($R_p$) and of the charge reversal current ($I_u$) by reversing the charge on in each case one individual electrode plate.

**12.** Method according to one of the preceding claims, **characterized by** the ice crystal volume ($v_{ice}$) in the electrolyte balancing areas ($S_i$) being determined from a defined relationship between the equilibrium concentration ($CGG_l$) of the acid in the electrolyte and the temperature (T) as well as the acid concentration ($C_i$) in the electrolyte using the formula:

$$v_{ice,i} = (1 - C_i / CGG_i) * v_i .$$

**13.** Method according to claim 12, **characterized by** a characteristic variable for the performance of the energy storage battery being determined as a function of the proportion of the ice crystal volume ($v_{Ice}$) to the electrolyte volume ($v_i$) in the electrolyte balancing areas ($S_l$) and the location ($S_l$) at which the ice crystal formation occurs.

**14.** Method according to one of the preceding claims, **characterized by** the state values for the electrolyte concentration ($r_i$) in the electrolyte balancing areas ($S_i$) being adapted as a function of the difference between the actual rest voltage ($U_{00}$) and the calculated rest voltage ($U_{00,g}$).

**15.** Monitoring device for an electrochemical energy storage battery having a measurement unit for measurement of the battery terminal voltage (U), of the battery terminal current (I) and of the battery temperature (T), and having an evaluation unit, **characterized in that** the evaluation unit is designed to carry out the method according to one of the preceding claims by programming of a microprocessor unit.

**Revendications**

**1.** Procédé pour déterminer la capacité résiduelle encore disponible d'une batterie d'accumulateurs, comprenant les étapes suivantes :

a) on subdivise le volume d'électrolyte (v) de la batterie d'accumulateurs en au moins deux fractions de volume d'électrolyte ($v_i$) superposées horizontalement, avec des chambres de bilan d'électrolyte ($S_i$), superposées horizontalement ;
b) on fixe au moins deux chambres de bilan d'électrodes-plaques ($P_k$), superposées, situées dans la méme répartition horizontale que les chambres de bilan d'électrolyte ($S_i$), et on associe les résistances de grille des électrodes-plaques ($R_k^M$) existant dans les zones des chambres de bilan d'électrodes-plaques aux chambres de bilan d'électrodes-plaques ($P_k$) et on répartit la capacité totale de stockage ($K^M$) des électrodes-plaques de la batterie d'accumulateurs en fractions de capacité de stockage ($K_k^M$) pour les chambres de bilan d'électrodes-plaques fixées ($P_k$),

chaque chambre de bilan d'électrodes-plaques étant liée à une chambre de bilan d'électrolyte associée, mais en revanche non liée aux autres chambres de bilan d'électrolyte,

c) on détermine les concentrations en électrolyte ($r_i$) des fractions de volume d'électrolyte ($v_i$) pour les chambres de bilan d'électrolyte ($S_i$), fixées,

d) on détermine les quantités de charge $(KE_k^M)$ converties respectivement dans les électrodes-plaques des chambres de bilan d'électrodes-plaques ($P_k$), et

e) on mesure le courant total (I) passant par les bornes de la batterie d'accumulateurs, la tension (U) aux bornes de la batterie d'accumulateurs et la température (T) de la batterie,

**caractérisé par** les étapes suivantes :

f) on calcule les quantités de charge $(RK_i^S)$ encore disponibles dans les fractions de volume d'électrolyte ($v_i$) dans les différentes chambres de bilan d'électrolyte ($S_i$), en fonction de la concentration actuelle ($r_i$) en électrolyte et du volume d'électrolyte ($v_i$) dans les chambres de bilan d'électrolyte ($S_i$) respectives ainsi que la température (T) de la batterie, en utilisant un modèle mathématique pour décrire le schéma électrique équivalent au moins avec comme grandeurs d'entrée les grandeurs des résistances de grille des électrodes-plaques $(R_k^M)$ des chambres de bilan d'électrodes-plaques ($P_k$) fixées selon l'étape b), les fractions de capacité de stockage $(K_k^M)$ des concentrations d'électrolyte ($r_i$) déterminées dans l'étape c) des fractions de volume d'électrolyte ($v_i$), les quantités de charge $(KE_k^M)$ converties dans l'étape d), et le courant total (I) et la tension aux bornes (U) mesurés dans l'étape e),

g) on calcule les quantités de charge $(RK_k^M)$ qui peuvent encore être prélevées dans les masses actives des chambres de bilan d'électrodes-plaques ($P_k$) respectives,

h) on calcule la capacité résiduelle ($RK_g$) encore disponible dans la batterie d'accumulateurs, comme grandeur caractéristique en fonction des quantités de charge $(RK_k^M)$ déterminées pour les chambres de bilan d'électrodes-plaques ($P_k$) et les quantités de charge $(RK_i^S)$ déterminées pour les chambres de bilan d'électrolyte ($S_i$), et qui sont encore disponibles dans les fractions de volume d'électrolyte ($v_i$) dans les chambres de bilan d'électrolyte ($S_i$) respectives.

2. Procédé selon la revendication 1,
**caractérisé en ce que**
la densité de l'acide des fractions de volume d'électrolyte ($v_i$) est une mesure de la concentration en électrolyte.

3. Procédé selon l'une des revendications 1 à 2,
**caractérisé en ce qu'**
on détermine les tensions de repos ($U_{00k}$) dans les chambres de bilan d'électrodes-plaques ($P_k$) fixées, en fonction des concentrations en électrolyte ($r_i$) dans les chambres de bilan d'électrolyte ($S_i$) associées.

4. Procédé selon la revendication 3,
**caractérisé en ce qu'**
on détermine les tensions de repos ($U_{00k}$) dans les chambres de bilan d'électrodes-plaques ($P_k$) fixées dans l'étape b), en outre en fonction de la température (T) de la batterie, mesurée, et des quantités de charge $(KE_k^M)$, converties, déterminées dans l'étape d).

5. Procédé selon l'une des revendications précédentes,
**caractérisé en ce qu'**
on calcule les intensités ($I_i$) des chambres de bilan d'électrolyte ($S_i$) à partir de l'intensité totale (I) passant dans les bornes de la batterie d'accumulateurs et d'un rapport de division dépendant de la concentration en électrolyte ($r_i$) dans la chambre de bilan d'électrolyte ($S_i$) respective.

6. Procédé selon l'une des revendications précédentes,
**caractérisé en ce qu'**
on calcule les intensités ($I_k$) des chambres de bilan d'électrodes-plaques ($P_k$) à partir de l'intensité totale (I) traversant les bornes de la batterie d'accumulateurs et d'un rapport de division dépendant de la tension de repos ($U_{00k}$) dans

la chambre de bilan d'électrodes-plaques ($P_k$) respective et des fractions de résistance $(R_k^M)$.

**7.** Procédé selon la revendication 6,
**caractérisé en ce que**
pour les intensités de décharge, on prend les intensités ($I_i$) des chambres de bilan d'électrolyte ($S_i$) égales aux intensités ($I_k$) calculées pour les chambres de bilan d'électrodes-plaques ($P_k$) associées.

**8.** Procédé selon l'une des revendications précédentes,
**caractérisé en ce qu'**
on calcule la quantité de charge $(KE_k^M)$ transformée après un instant (dt) dans la chambre de bilan d'électrodes-plaques ($P_k$) à partir de la capacité de stockage $(KE_k^M)$ convertie jusque immédiatement avant cette période dans cette chambre de bilan d'électrodes-plaques ($P_k$) et de la charge $(I_k^M \times dt)$ traversant dans cette période (dt) la chambre de bilan d'électrodes-plaques ($P_k$) :

$$KE_k^M\ (t_1 + dt) = KE_k^M\ (t_1) + I_k^M \cdot dt.$$

**9.** Procédé selon l'une des revendications précédentes,
**caractérisé en ce qu'**
on calcule la quantité de charge $(RK_k^M)$ encore disponible des électrodes-plaques dans les différentes chambres de bilan d'électrodes-plaques ($P_k$) à partir de la fraction de capacité de stockage $(K_k^M)$ de la chambre de bilan d'électrodes-plaques ($P_k$) respective diminuée de la quantité de charge $(KE_k^M)$ prélevée jusqu'à la période (dt) de la masse active dans la chambre de bilan d'électrodes-plaques ($P_k$) et aussi diminuée de la charge ($I_k^M \times dt$), pendant la période (dt) dans les électrodes-plaques de la chambre de bilan d'électrodes-plaques ($P_k$).

**10.** Procédé selon l'une des revendications précédentes,
**caractérisé en ce qu'**
on détermine la capacité résiduelle en fonction du courant de transfert ($I_u$) sur les électrodes-plaques entre les emplacements à tension de repos élevée ($D_{00,x}$) et les emplacements à tension de repos faible ($U_{00,y}$), le courant de transfert ($I_u$) se calculant à partir de la résistance de polarisation ($R_p$) à la surface des électrodes-plaques et de la somme des résistances de grille ($R_n$) entre les emplacements (x, y) en appliquant la formule suivante :

$$I_U = \left(U_{00,x} - U_{00,y}\right) \cdot \left(R_{P,x} + R_{P,y} + \sum_{n=x}^{y} R_n\right)$$

**11.** Procédé selon l'une des revendications précédentes,
**caractérisé en ce qu'**
on calcule la tension de repos ($U_{00,g}$) de la capacité d'accumulateurs comme grandeur caractéristique en fonction de l'état de charge des différentes chambres de bilan d'électrodes-plaques ($P_k$), des tensions de repos ($U_{00,k}$) dans les chambres de bilan d'électrodes-plaques ($P_k$), des fractions de résistance $(R_k^M)$, de la résistance de polarisation ($R_p$) et du courant de transfert ($I_u$) par le transfert de charge sur chacune des électrodes-plaques.

**12.** Procédé selon l'une des revendications précédentes,
**caractérisé en ce qu'**
on détermine le volume de cristaux de glace ($v_{Eis}$) dans les chambres de bilan d'électrolyte ($S_i$) à partir d'une relation définie entre la concentration à l'équilibre ($CGG_i$) de l'acide dans les électrolytes et la température (T) ainsi que la concentration en acide ($C_i$) dans les électrolytes selon la formule suivante:

$$v_{Eis,i} = (1 - C_i/CGG_i) \cdot v_i$$

**13.** Procédé selon la revendication 12,
**caractérisé en ce qu'**
on détermine une grandeur caractéristique de la capacité de puissance de la batterie d'accumulateurs en fonction de la fraction du volume de cristaux de glace ($v_{Eis}$) et du volume d'électrolyte ($v_i$) dans les chambres de bilan d'électrolyte ($S_i$) et l'emplacement ($S_i$) où se forment des cristaux de glace.

**14.** Procédé selon l'une des revendications précédentes,
**caractérisé en ce qu'**
on adapte les valeurs d'état de la concentration en électrolyte (n) dans les chambres de bilan d'électrolyte ($S_i$) en fonction de la différence entre la tension de repos ($U_{00}$) effective et la tension de repos ($U_{00,g}$), calculée.

**15.** Installation de surveillance d'une batterie d'accumulateurs électrochimique comportant une unité de mesure pour mesurer la tension (U) aux bornes de la batterie, le courant (1) dans les bornes et la température (T) de la batterie ainsi qu'une unité d'exploitation,
**caractérisée en ce que**
l'unité d'exploitation est réalisée pour la mise en oeuvre du procédé selon l'une des revendications précédentes par programmation d'une unité à microprocesseur.

Fig. 1

Fig. 2

Fig. 3

Fig. 4

EP 1 562 049 B1

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2242510 C1
- DE 4007883 A1
- DE 19543874 A1
- DE 3901680 C1
- DE 4339568 A1
- DE 19847648 A1

**In der Beschreibung aufgeführte Nicht-Patentliteratur**

- **D. U. Sauer.** Modelling of Local Conditions in flooded Lead / Acid Batteries in Photovoltaic Systems, in. *Journal of Power Sources,* 1997, vol. 64, 181-187